(19) Europäisches Patentamt / European Patent Office / Office européen des brevets

(11) **EP 3 390 697 B1**

(12) **FASCICULE DE BREVET EUROPEEN**

(45) Date de publication et mention
de la délivrance du brevet:
**29.07.2020 Bulletin 2020/31**

(21) Numéro de dépôt: **16809829.1**

(22) Date de dépôt: **14.12.2016**

(51) Int Cl.:
**C30B 15/04** (2006.01)    **C30B 29/06** (2006.01)

(86) Numéro de dépôt international:
**PCT/EP2016/081066**

(87) Numéro de publication internationale:
**WO 2017/102882 (22.06.2017 Gazette 2017/25)**

(54) **FOUR DE CRISTALLISATION D'UN LINGOT EN MATÉRIAU SEMI-CONDUCTEUR ENRICHI EN OXYGÈNE**

OFEN ZUM KRISTALLISIEREN EINES BLOCKS AUS MIT SAUERSTOFF ANGEREICHERTEM HALBLEITERMATERIAL

FURNACE FOR CRYSTALLIZING AN INGOT MADE OF OXYGEN-ENRICHED SEMICONDUCTOR MATERIAL

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **14.12.2015 FR 1562313**

(43) Date de publication de la demande:
**24.10.2018 Bulletin 2018/43**

(73) Titulaire: **Commissariat à l'Énergie Atomique et aux Énergies Alternatives
75015 Paris (FR)**

(72) Inventeurs:
- **VEIRMAN, Jordi**
  **73290 La Motte Servalex (FR)**
- **ALBARIC, Mickaël**
  **73290 La Motte-Servolex (FR)**
- **STADLER, Jacky**
  **74930 Reignier (FR)**

(74) Mandataire: **Cabinet Camus Lebkiri
25 rue de Maubeuge
75009 Paris (FR)**

(56) Documents cités:
DE-A1- 3 215 620    JP-A- S5 669 298
US-A- 5 471 949    US-A- 5 853 480

**Description**

**DOMAINE TECHNIQUE**

La présente invention est relative à un procédé de fabrication d'un lingot en matériau semi-conducteur enrichi en oxygène et à un four de cristallisation permettant de former un tel lingot.

**ÉTAT DE LA TECHNIQUE**

Le procédé Czochralski (Cz) est une technique couramment employée pour former des lingots en silicium monocristallin. Elle consiste à faire fondre dans un creuset une quantité de silicium, appelée charge ou masse, et à cristalliser le silicium à partir d'un germe monocristallin. Le germe, orienté selon un axe cristallographique du cristal à former, est d'abord trempé dans le bain de silicium fondu. Puis, il est entraîné en rotation et tiré lentement vers le haut. Ainsi, le lingot de silicium solide croît progressivement en se nourrissant du bain.

Le bain de silicium fondu contient une importante quantité d'oxygène. Cet oxygène peut provenir du creuset, habituellement formé de quartz ou de silice, car celui-ci se dissout partiellement dans le bain sous l'effet de la température, et/ou de la charge de silicium (i.e. du silicium à l'état solide). Au cours de la cristallisation d'un lingot, la majeure partie de l'oxygène contenu dans le bain (environ 99 %) s'échappe dans l'atmosphère du four de cristallisation, brassée par des flux de gaz inerte. Une faible partie (environ 1 %) de l'oxygène s'incorpore dans le lingot. La quantité d'oxygène incorporée dans le lingot dépend de nombreux paramètres du procédé de tirage, notamment de la vitesse de tirage du lingot, des vitesses de rotation du creuset et du germe, et de la pression dans l'enceinte du four.

En dépit du faible taux d'incorporation de l'oxygène dans le lingot, l'oxygène est généralement l'impureté dont la concentration est la plus élevée dans un lingot en silicium de type Cz (entre $10^{17}$ et $2.10^{18}$ atomes/cm$^3$). L'oxygène est présent sous forme interstitielle, c'est-à-dire que les atomes d'oxygène occupent des positions interstitielles dans le réseau cristallin du silicium. Si l'oxygène interstitiel n'a pas d'activité électrique ou mécanique de premier ordre, il est par contre très réactif et peut former des défauts qui influent de manière importante sur les propriétés électriques et mécaniques du silicium. A titre d'exemple, à des températures comprises entre 350 °C et 500 °C, l'oxygène interstitiel forme des agglomérats appelés Doubles Donneurs Thermiques (DDT) qui modifient la résistivité électrique du silicium en créant des électrons libres. A plus haute température, l'oxygène interstitiel participe à la formation de précipités de silice permettant de piéger des impuretés métalliques présentes dans le silicium. Un effet getter peut ainsi être obtenu.

La formation de ces défauts à base d'oxygène est intimement liée à la concentration en oxygène dans le silicium. Par conséquent, il est nécessaire de contrôler la concentration en oxygène dans le silicium pour tirer pleinement avantage de ces défauts, ou au contraire, limiter leur impact dans les dispositifs semi-conducteurs.

Pour y parvenir, des procédés de contrôle de la concentration en oxygène dans le lingot ont été développés. La plupart de ces procédés consiste à accentuer ou limiter le phénomène d'incorporation de l'oxygène dans le lingot, en jouant sur les paramètres du procédé de tirage (pression et débit de gaz inerte dans l'enceinte du four, vitesses de rotation du creuset et du germe...). Toutefois, ces procédés modifient de la même manière la vitesse d'incorporation des autres impuretés du silicium, et notamment les impuretés métalliques provenant de la charge de silicium. Ainsi, lorsqu'on augmente la concentration en oxygène dans le lingot, la concentration en impuretés métalliques est également augmentée. Or une concentration en impuretés métalliques élevée peut être préjudiciable pour le fonctionnement des dispositifs semi-conducteurs. En outre, ces procédés sont empiriques et requièrent de nombreux essais avant d'être optimisés.

Le brevet US4545849 décrit un procédé pour augmenter la concentration en oxygène d'un lingot dans le but de rendre cette concentration uniforme le long du lingot. Une pièce de silice (SiO$_2$) de forme toroïdale est fixée au fond du creuset et immergée par le bain de silicium fondu. Cette pièce se dissout sous l'effet de la température et libère l'oxygène qu'elle contient.

Toutefois, ce procédé ne permet pas de maîtriser l'augmentation de la concentration en oxygène au cours de la cristallisation du lingot, puisque la dissolution de la pièce dépend de la température du bain et de la forme de la pièce, toutes les deux figées.

Le document DE3215620A1 divulgue un four de cristallisation permettant de fabriquer un lingot de silicium dont la concentration en oxygène est uniforme. Ce four comprend un creuset ayant un axe de symétrie et destiné à contenir un bain de silicium, un système de tirage du lingot à partir du bain de silicium et une pièce en quartz, en forme d'anneau d'axe colinéaire à l'axe de symétrie du creuset. La pièce en quartz flotte à la surface du bain de silicium, enrichit le bain en oxygène et empêche l'oxygène du bain de s'échapper. La pièce en quartz est montée mobile en translation par rapport à l'axe de symétrie du creuset au moyen d'un système de translation.

Le document US5853480 décrit par ailleurs un four de cristallisation permettant de fabriquer un lingot semi-conducteur dans lequel les précipités d'oxygène et les donneurs thermiques sont uniformément répartis. Ce four comprend un creuset, un système de tirage de lingot et un élément chauffant en graphite configuré pour chauffer une région spécifique du lingot et monté mobile en translation par rapport à l'axe de symétrie du creuset au moyen d'un premier système de translation. Le four comprend en outre un bouclier thermique monté mobile en translation par rapport à l'axe de symétrie du creuset au moyen d'un deuxième système de translation, distinct du premier système de translation.

## RÉSUMÉ DE L'INVENTION

L'invention vise à contrôler l'enrichissement en oxygène d'un lingot en matériau semi-conducteur au cours de sa cristallisation.

Selon un premier aspect de l'invention, on tend vers cet objectif en prévoyant un procédé de fabrication de lingot comprenant les étapes suivantes :

- préparer un bain de matériau semi-conducteur en fusion dans un creuset ayant un axe de symétrie ;
- tremper un germe dans le bain de matériau semi-conducteur en fusion ;
- cristalliser le lingot à partir du bain de matériau semi-conducteur en fusion, en tirant le germe dans une direction colinéaire à l'axe de symétrie du creuset ;

et, pendant l'étape de cristallisation du lingot, l'opération suivante :

∘ plonger dans le bain de matériau semi-conducteur en fusion au moins une partie d'une pièce constituée d'un matériau contenant de l'oxygène, la pièce comprenant au moins un segment d'un anneau, d'axe colinéaire à l'axe de symétrie du creuset.

La partie de la pièce plongée dans le bain de matériau semi-conducteur en fusion présente une hauteur qui varie au cours de la cristallisation du lingot, de façon à atteindre une concentration en oxygène cible dans chaque fraction du lingot.

Ainsi, comme dans le procédé du brevet US4545849, une pièce de forme annulaire est plongée dans le bain de matériau semi-conducteur en fusion pour réaliser un apport supplémentaire d'oxygène. Cette pièce est constituée d'un matériau qui renferme des atomes d'oxygène, tel que le quartz ou la silice.

A la différence du procédé de l'art antérieur, le procédé de fabrication selon l'invention permet de contrôler l'enrichissement en oxygène du bain, et donc du lingot, en augmentant ou diminuant la surface de contact entre le bain et la pièce contenant l'oxygène. Cette variation de surface est obtenue grâce au fait que la pièce peut être plongée plus ou moins profondément dans le bain. La hauteur de la partie immergée de la pièce, autrement dit la profondeur à laquelle la pièce est plongée dans le bain, dépend de la concentration en oxygène que l'on souhaite atteindre dans la fraction du lingot en cours de cristallisation.

De préférence, l'anneau a un diamètre intérieur compris entre 70 % et 95 % du diamètre intérieur du creuset. Autrement dit, la pièce est disposée à la périphérie du creuset, dont l'axe de symétrie correspond à l'axe de tirage du lingot. Ainsi, la pièce n'a qu'un impact limité sur la convection du silicium fondu au centre du creuset, et donc sur la cristallisation du lingot.

Avantageusement, la pièce comprend une pluralité de segments d'anneau disposés de façon annulaire (anneau discontinu) autour du lingot ou est formée d'un anneau entier (i.e. anneau continu). Le fait qu'un tel anneau (continu ou discontinu) soit disposé de façon coaxiale autour du lingot en formation préserve l'homogénéité du bain de matériau semi-conducteur en fusion et garantit que la concentration en oxygène est symétrique sur le diamètre du lingot.

Dans un mode de mise en oeuvre préférentiel du procédé de fabrication, la section de la pièce présente une pointe dirigée vers le fond du creuset selon une direction parallèle à l'axe de symétrie du creuset. Cette géométrie particulière permet de réduire les perturbations dans le bain de matériau semi-conducteur en fusion, lorsque la pièce s'enfonce dans le bain, et de faire varier l'apport d'oxygène dans le bain progressivement. Le contrôle de la concentration en oxygène dans le lingot est alors plus précis.

Selon un développement du premier aspect de l'invention, le procédé de fabrication comporte en outre les étapes suivantes :

- déterminer une relation donnant la surface de contact entre la pièce et le bain de matériau semi-conducteur en fusion en fonction de la profondeur à laquelle la pièce est plongée dans le bain ;
- calculer, pour chaque fraction du lingot, un incrément de concentration en oxygène à apporter pour atteindre la concentration en oxygène cible, compte tenu de la concentration en oxygène de base du lingot ; et
- déterminer une profondeur à laquelle plonger la pièce lors de la cristallisation de chaque fraction du lingot, à partir de l'incrément de concentration en oxygène correspondant à ladite fraction, de la relation donnant la surface de contact et de la surface de contact entre le creuset et le bain de matériau semi-conducteur en fusion.

La concentration en oxygène de base du lingot à enrichir en oxygène est avantageusement déterminée en cristallisant un lingot de référence et en mesurant la concentration en oxygène le long du lingot de référence.

Le procédé de fabrication selon l'invention peut également présenter une ou plusieurs des caractéristiques ci-dessous, considérées individuellement ou selon toutes les combinaisons techniquement possibles :

- le creuset et la pièce sont entrainés en rotation pendant l'étape de cristallisation, dans un même sens de rotation et à une même vitesse de rotation ;
- le creuset et la pièce sont constitués du même matériau contenant de l'oxygène ;
- le diamètre du lingot est compris entre 20 % et 45 % du diamètre intérieur du creuset.

Un deuxième aspect de l'invention concerne un four de cristallisation permettant de contrôler la concentration en oxygène dans un lingot en matériau semi-conducteur lors de sa fabrication.

Ce four comporte les éléments suivants :

- un creuset ayant un axe de symétrie et destiné à contenir un bain de matériau semi-conducteur en fusion ; et
- un système de tirage du lingot à partir du bain de matériau semi-conducteur en fusion, dans une direction colinéaire à l'axe de symétrie du creuset ; et
- une pièce constituée d'un matériau contenant de l'oxygène, ladite pièce comprenant au moins un segment d'un anneau, d'axe colinéaire à l'axe de symétrie du creuset.

En outre, le creuset et la pièce sont montés de façon à pouvoir exécuter un mouvement relatif de translation parallèlement à l'axe de symétrie du creuset.

De préférence, l'anneau a un diamètre intérieur compris entre 70 % et 95 % du diamètre intérieur du creuset.

Dans un mode de réalisation préférentiel du four de cristallisation, la pièce est montée mobile en translation parallèlement à l'axe de symétrie du creuset.

Avantageusement, la pièce est en outre montée en rotation autour de l'axe de symétrie du creuset.

Enfin, le four peut comprendre en outre un bouclier thermique disposé autour de l'axe de symétrie du creuset et monté mobile en translation parallèlement à l'axe de symétrie du creuset au moyen d'un système de translation. La pièce en forme d'anneau est alors avantageusement fixée sur le système de translation de l'écran thermique.

## BRÈVE DESCRIPTION DES FIGURES

D'autres caractéristiques et avantages de l'invention ressortiront clairement de la description qui en est donnée ci-dessous, à titre indicatif et nullement limitatif, en référence aux figures annexées, parmi lesquelles :

- les figures 1A et 1B illustrent un procédé de fabrication de lingot faisant intervenir une pièce riche en oxygène, d'après un premier aspect de l'invention ;
- la figure 2 représente une géométrie particulière de pièce riche en oxygène utilisée dans un mode de mise en œuvre préférentiel du procédé de fabrication ;
- la figure 3 est une vue de coupe transversale d'un four de cristallisation selon un deuxième aspect de l'invention ;
- les figures 4 et 5 représentent des modes de réalisation d'un système de translation permettant de mettre en mouvement la pièce riche en oxygène dans le four de cristallisation selon un deuxième aspect de l'invention ;
- les figures 6 à 9 illustrent un exemple de mise en œuvre du contrôle de la concentration en oxygène au moyen de la pièce riche en oxygène, d'après le procédé de fabrication de l'invention.

Pour plus de clarté, les éléments identiques ou similaires sont repérés par des signes de référence identiques sur l'ensemble des figures.

## DESCRIPTION DÉTAILLÉE D'AU MOINS UN MODE DE RÉALISATION

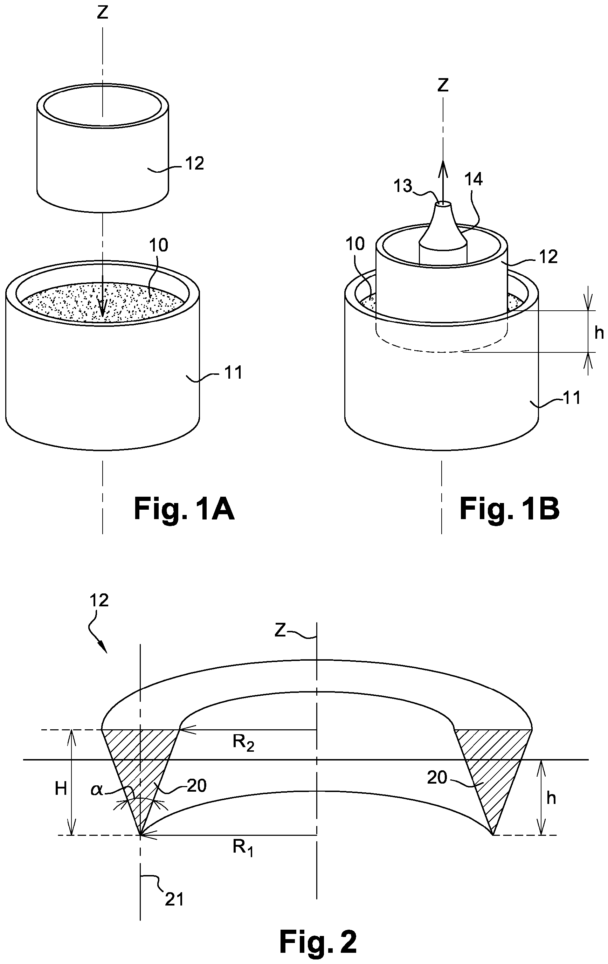

Les figures 1A et 1B représentent schématiquement des étapes d'un procédé de fabrication d'un lingot en matériau semi-conducteur enrichi en oxygène. Ces figures illustrent plus particulièrement la manière dont est réalisé le contrôle de la concentration en oxygène dans le lingot.

Lors d'une première étape illustrée à la figure 1A, on prépare tout d'abord un bain 10 de matériau semi-conducteur en fusion. Une charge solide de matériau semi-conducteur, par exemple du silicium, est disposée dans un creuset 11, puis fondue. Le creuset 11 a globalement la forme d'un cylindre fermé à une extrémité par un fond et présente un axe de symétrie z vertical.

Le creuset 11 constitue une première source d'oxygène vis-à-vis du bain de silicium 10, puisqu'il est habituel-

lement formé de silice (SiO$_2$) ou de quartz. Le quartz est un matériau qui contient principalement de la silice, avec des traces de différents éléments ou composés tels que Al, Li, B, Fe, Mg, Ca, Ti, Rb, Na et OH. Sous l'effet de la température, le creuset 11 se dissout lentement dans le bain de silicium 10, à une vitesse de l'ordre de 1 μg/cm$^2$/s. Le bain de silicium 10 incorpore ainsi l'oxygène et les éventuelles autres impuretés contenus dans le matériau du creuset 11. La charge solide de silicium peut aussi contenir des impuretés, dont des métaux et de l'oxygène.

À l'étape de la figure 1B, après fusion complète de la charge de silicium, un germe cristallin 13 est trempé dans le bain 10 au centre du creuset 11. Cette opération a pour effet d'amorcer la cristallisation d'un lingot 14 à partir du silicium en fusion. Puis, la cristallisation du lingot 14 se poursuit en éloignant le germe 13 du creuset 11 dans la direction de l'axe z, comme illustrée sur la figure 1B. Ainsi, l'axe de symétrie z du creuset correspond également à l'axe de tirage du lingot 14.

Le procédé de fabrication prévoit l'utilisation, au cours de l'étape de cristallisation, d'une deuxième source d'oxygène afin d'augmenter la concentration en oxygène du bain de silicium 10. Cette deuxième source est de préférence constituée d'une pièce 12 en forme d'anneau, comme illustré sur la figure 1B. Alternativement, la pièce 12 peut comprend seulement une partie ou segment d'un anneau, voire plusieurs segments d'un même anneau disposé autour de l'axe z. Ainsi, la pièce 12 peut être en forme d'anneau continu (figure 1B) ou discontinu (non représenté) lorsque plusieurs segments d'anneau sont disposés de façon annulaire. Le creuset 11 et la pièce 12 sont coaxiaux, c'est-à-dire que l'axe de l'anneau est confondu avec l'axe de symétrie z du creuset.

La pièce 12 est plongée dans le bain de silicium 10 à une profondeur h qui varie au cours de la cristallisation, en fonction de la concentration en oxygène que l'on souhaite atteindre dans chaque zone ou fraction du lingot. Plus la pièce 12 est plongée profondément dans le bain 10, plus la surface de contact entre la pièce et le bain est grande et plus l'apport en oxygène dans le bain 10 est important. Comme l'oxygène du bain 10 est ensuite incorporé dans le lingot 14, ce dernier contiendra une quantité plus importante d'oxygène. En d'autres termes, la variation de la profondeur h permet de moduler l'augmentation de la concentration en oxygène dans le lingot.

La pièce 12 peut être partiellement ou totalement immergée selon les besoins en oxygène. La profondeur h correspond à la distance entre la surface du bain de silicium 10 et l'extrémité inférieure de la pièce 12 située sous la surface du bain. Jusqu'à ce que l'extrémité supérieure de la pièce 12 soit également immergée, la profondeur h équivaut à la hauteur de la partie immergée de la pièce. On désigne par « hauteur » la dimension mesurée parallèlement à l'axe de symétrie z du creuset. De préférence, l'extrémité supérieure de la pièce 12 ne descend pas en dessous de la surface du bain 10.

La pièce 12 est avantageusement formée du même matériau que le creuset 11, et de préférence en silice ou quartz. Ces matériaux sont préférés, car ils contiennent de faibles quantités d'impuretés indésirables (i.e. autres que l'oxygène). La concentration en impuretés métalliques est par exemple de l'ordre de 10 ppm (partie par million) dans le quartz d'un creuset. En outre, la surface de la pièce plongée dans le bain est faible au regard de la surface de contact existant entre le creuset et le bain liquide. La concentration en impuretés autres que l'oxygène ajoutée par la pièce 12 est donc négligeable.

Malgré sa position à la surface du bain 10, la pièce 12 n'interfère pas de façon significative dans la cristallisation du lingot 14, grâce au fait que le diamètre intérieur de l'anneau est avantageusement compris entre 70 % et 95 % du diamètre intérieur du creuset 11. La pièce 12 se trouve ainsi éloignée du lingot 14, en périphérie du creuset 11. À titre de comparaison, le diamètre du lingot 14 est généralement compris entre 20 % et 45 % du diamètre intérieur du creuset. Par exemple, le diamètre extérieur du creuset 11 vaut 508 mm (soit 20"), le diamètre intérieur du creuset 11 est égal à 488 mm, le diamètre intérieur de l'anneau est égal à 360 mm et le diamètre des lingots pouvant être cristallisés dans ce creuset est compris entre 152,4 mm et 228,6 mm (6"-9").

La forme annulaire (continue ou discontinue) de la pièce 12 permet de préserver l'homogénéité du bain de silicium 10, notamment en ce qui concerne la concentration en oxygène. Le profil de la concentration en oxygène sur le diamètre du lingot 14 est alors symétrique. Cette forme permet également à pièce 12 de tourner autour de l'axe z sans créer trop de remous dans le bain.

La pièce 12 présente avantageusement une symétrie de révolution par rapport à l'axe z. Sa section est alors constante sur toute la circonférence de l'anneau. Dans l'exemple des figures 1A et 1B, cette section est rectangulaire car l'anneau est un cylindre droit et creux. Un anneau de section carré ou ronde (i.e. un tore) est également possible.

La figure 2 représente une autre géométrie, particulièrement avantageuse, de la pièce 12, utilisée dans un mode de mise en œuvre préférentiel du procédé de fabrication. L'anneau possède ici, dans chacun des demi-plans séparés par l'axe z, une section présentant une pointe 20. Cette pointe 20 est dirigée vers le fond du creuset selon une direction 21 parallèle à l'axe z. Grâce à cette pointe, la pièce 12 occasionne peu de remous lorsqu'elle pénètre dans le bain de silicium en fusion. Cela permet également d'augmenter la concentration en oxygène du bain de façon progressive, au fur et à mesure que la ponte s'enfonce dans le bain. L'apport d'oxygène peut ainsi prendre toute une plage de valeurs entre 0, lorsque la pointe s'apprête à rentrer dans le bain, et une valeur maximale, lorsque la pièce 12 est entièrement plongée dans le bain.

La section de la pièce 12 peut également comprendre plusieurs pointes dirigées vers le fond du creuset, par exemple en dents de scie.

Comme illustrée sur la figure 2, la section de l'anneau est de préférence un triangle isocèle dont le sommet principal constitue l'extrémité inférieure de la pièce 12. La base du triangle isocèle constitue alors la face supérieure de la pièce 12. L'angle α au sommet principal du triangle détermine à quel rythme augmente la concentration en oxygène du bain lorsque la pièce 12 s'enfonce dans le bain. En effet, plus cet angle α est grand, plus la surface de contact entre la pièce 12 et le bain de silicium augmente rapidement avec h. Il est avantageusement compris entre 10° et 150°. Par exemple, si le diamètre moyen de l'anneau $R_1$ est égal à 21,5 cm et le diamètre intérieur de l'anneau $R_2$ est égal à 18 cm, l'augmentation de la surface de contact par cm de la hauteur h est de 542 $cm^2$ pour un angle α de 10° et de 2087 $cm^2$ pour un angle a de 150°.

La géométrie triangulaire rend linéaire (en première approximation) l'augmentation de la concentration en oxygène du bain avec la profondeur h. En effet, la quantité ajoutée d'oxygène dans la partie du lingot en cours de cristallisation est proportionnelle à la surface de contact entre la pièce et le bain, elle-même proportionnelle à la hauteur h de la partie immergée de la pièce 12. Enfin, la forme triangulaire permet de balayer une large plage de surface de contact, et donc d'atteindre avec une seule pièce des valeurs élevées de la concentration en oxygène dans le bain.

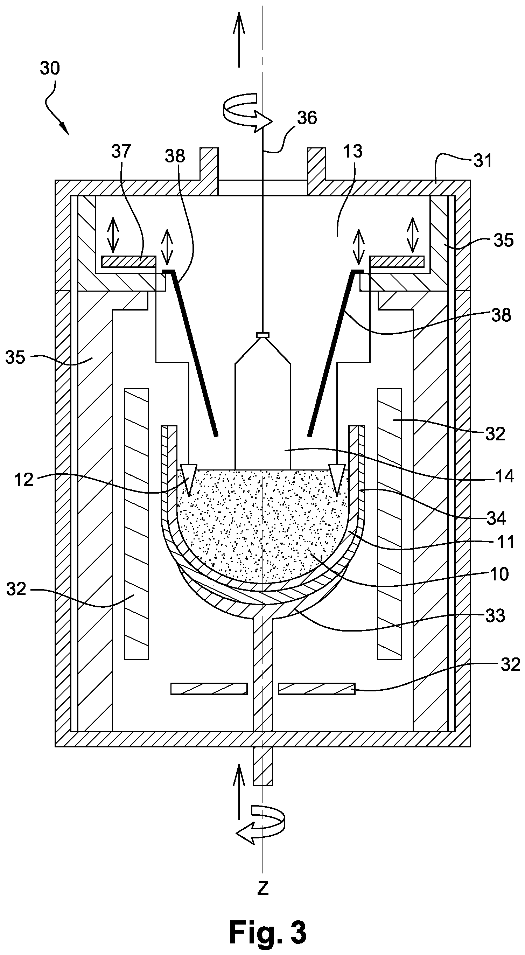

La figure 3 représente en vue de coupe transversale un four de cristallisation 30 configuré pour la mise en œuvre du procédé de fabrication des figures 1A et 1B.

Ce four de cristallisation 30 contient, dans une enceinte 31 appelée « cuve », le creuset 11 destiné à recevoir la charge de silicium et un dispositif de chauffage 32 permettant de faire fondre cette charge de silicium pour former le bain de silicium 10. Le creuset 11 est fixé à un support 33, qui peut être entrainé en rotation autour de l'axe z, par exemple à une vitesse de 8 tours/min. Un contre-creuset 34 peut être disposé entre le creuset 11 et son support 33. Le dispositif de chauffage 32 peut notamment comprendre une pluralité de résistances thermiques disposées en regard des flancs et du fond du creuset 11.

Les parois intérieures de l'enceinte 31 peuvent être recouvertes d'un matériau isolant thermiquement 35, afin de réduire la dissipation thermique vers l'extérieur du four 30.

De façon classique, le four 30 comprend un système de tirage 36 de lingot à partir de la charge fondue de silicium. Ce système de tirage 36, dont une partie seulement est représentée sur la figure 3, permet d'amener un germe 13 en contact avec le bain de silicium 10 et de tirer ce germe selon l'axe z, afin d'extraire du bain un lingot 14 en silicium cristallin. Le système de tirage 36 peut en outre entraîner le germe 13 et le lingot 14 en rotation autour de l'axe z, par exemple à une vitesse de 10 tours/min.

Le four 30 comprend également la pièce 12 en forme d'anneau ou de segment(s) d'anneau. La pièce 12 est disposée dans le creuset 11 autour de l'axe z et destinée à enrichir le bain de silicium 10 en oxygène, comme cela a été décrit en relation avec les figures 1A et 1B. Le creuset 11 et la pièce 12 sont en mouvement relatif de translation selon l'axe z.

Dans un mode de réalisation préférentiel du four, la pièce 12 est montée en translation parallèlement à l'axe z. Elle est donc mobile par rapport à l'enceinte 31 du four 30. Le creuset 11 peut également être mobile et monté en translation parallèlement à l'axe z, afin de compenser l'abaissement de la surface du bain 10. De cette façon, la cristallisation du lingot a toujours lieu à la même hauteur dans le four 30, dans une zone où la température du bain est parfaitement maîtrisée.

La pièce mobile 12 est fixée à un système de translation 37, qui occupe la partie supérieure du four. Ce système de translation 37 comporte par exemple des tiges en graphite animées d'un mouvement vertical, par exemple par une vis sans fin. Les tiges en graphite s'étendent jusqu'au creuset 11 et ont une extrémité fixée à la pièce 12.

Le four de cristallisation 30 peut être équipé d'un bouclier thermique 38 pour faire écran à la chaleur rayonnante émise par le bain de silicium 10. Ce bouclier 38 est généralement monté en translation par rapport à l'enceinte 31 du four, parallèlement à l'axe de symétrie z du creuset 11.

Dans un mode de réalisation du four, la pièce 12 de forme annulaire est avantageusement fixée au système de translation du bouclier thermique 38. La pièce 12 est alors mise en mouvement par ce même système. On peut ainsi faire l'économie du système de translation 37, prévu spécifiquement pour la pièce 12.

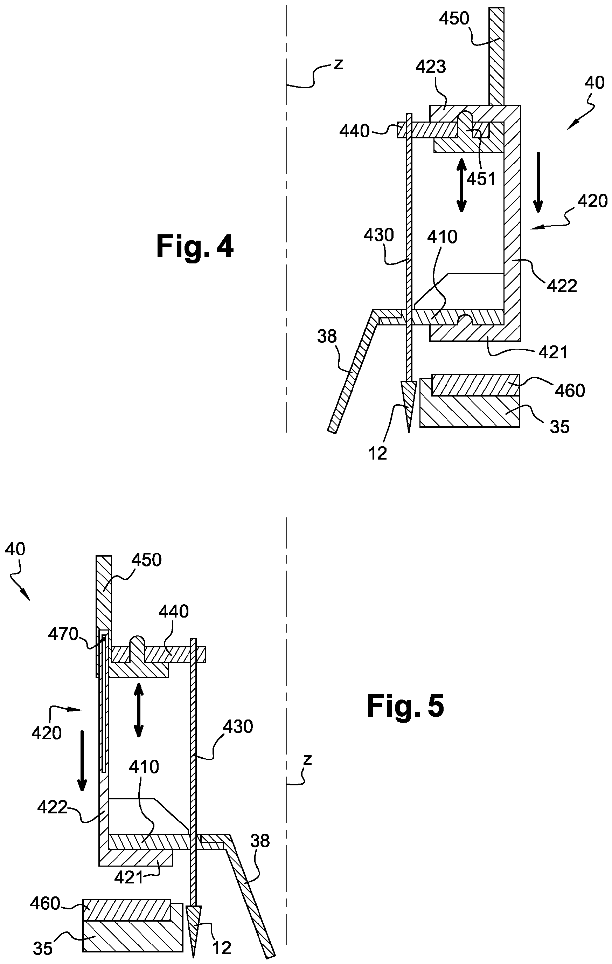

Les figures 4 et 5 représentent deux modes de réalisation d'un système de translation 40 permettant de mettre en mouvement à la fois le bouclier thermique 38 et la pièce 12 à tremper dans le bain de silicium. Ce système 40 est de préférence conçu pour pouvoir translater (verticalement) le bouclier thermique 38 et la pièce 12 simultanément, mais également pour translater (verticalement) la pièce 12 indépendamment du bouclier 38.

Le système de translation 40 présente avantageusement une symétrie par rapport à l'axe z. Dans un souci de simplification, le système de translation 40 est donc représenté sur les figures 4 et 5 uniquement dans un demi-plan de coupe passant par l'axe de symétrie z.

Dans la vue de coupe de la figure 4, le système de translation 40 comporte une première structure de support 410 disposée à l'horizontale et sur laquelle est fixé le bouclier 38. Dans le prolongement de cette première structure 410 dite « support de bouclier », le système de translation 40 comporte une rallonge de support 420. Cette rallonge de support 420 présente, de préférence, une section en forme de « U ». Elle comporte successivement une première portion horizontale 421 sur laquelle est fixée le support de bouclier 410, une deuxième portion 422 qui s'étend verticalement, c'est-à-dire parallèlement à l'axe de symétrie z, et une troisième portion 423 horizontale. Le bouclier 38, le support de bouclier 410 et la rallonge de support 420 sont montés ensemble de façon solidaire, c'est-à-dire de sorte qu'il n'y ait pas de mouvement relatif entre eux.

Le système de translation 40 comporte également une deuxième structure horizontale de support 440, dite «support de pièce», une tige 430 s'étendant verticalement, et un membre de support 450 mobile en translation. La pièce 12 est fixée à l'extrémité de la tige 430. Le support de pièce 440 est solidaire de la tige 430 et du membre mobile 450. Par conséquent, une fois le montage réalisé, il ne peut y avoir de mouvement relatif entre la pièce 12, la tige 430, le support de pièce 440 et le membre mobile 450. Le membre mobile en translation 450 possède une portion en saillie 451, capable de se loger à l'intérieur de la troisième portion 423 horizontale de la rallonge de support 420.

Dans une configuration symétrique, le bouclier 38, la première structure de support 410 et la deuxième structure de support 440 ont de préférence une forme annulaire (d'axe z), à l'instar de la pièce 12. En outre, le système de translation 40 comporte avantageusement deux rallonges de support 420, deux membres de support 450 mobiles et au moins deux (préférentiellement quatre) tiges 430, disposés de façon symétrique par rapport à l'axe z, autrement dit de chaque côté du four.

Le fonctionnement du système de translation 40 selon la figure 4 est le suivant.

Initialement, la portion en saillie 451 du membre mobile 450 est emboîtée dans la rallonge de support 420. La troisième portion 423 de la rallonge 420 repose sur une portion horizontale du membre mobile 450, sous l'effet de son poids. En d'autres termes, le membre mobile 450 porte la rallonge de support 420. Le membre mobile 450 est ensuite translaté vers le bas, en direction du creuset, ce qui a pour effet d'abaisser simultanément le support de pièce 440, la rallonge de support 420 et le support de bouclier 410. Le bouclier 38 et la pièce 12 sont ainsi descendus jusqu'à ce que la première portion 421 de la rallonge de support 420 vienne en appui contre une cale d'ajustement 460. Cette cale 460 permet de maintenir le bouclier 38 à une distance prédéterminée du bain de silicium en fusion.

En poursuivant le mouvement de translation, la portion en saillie 451 du membre mobile 450 est délogée de la rallonge de support 420. Le membre mobile 450 coulisse contre la rallonge de support 420 (qui est immobile), le long de la deuxième portion 422. Cela a pour effet d'abaisser davantage le support de pièce 440, et donc la pièce 12 située à l'extrémité des tiges 430. Ainsi, la profondeur de trempe de la pièce 12 dans le bain de silicium est contrôlée indépendamment de la hauteur du bouclier 38 en déplaçant le membre mobile 450, une fois qu'il est désolidarisé de la rallonge de support 420.

À l'issue de la cristallisation du lingot, le membre mobile 450 est translaté vers le haut. Cela permet de remonter la pièce 12, d'abord seule, puis avec le bouclier 38 dès que la portion en saillie 451 arrive en butée contre la troisième portion 423 de la rallonge 420.

Dans le four de cristallisation selon le deuxième aspect de l'invention, la cale d'ajustement 460 repose avantageusement sur une portion horizontale de matériau isolant thermiquement 35. Ce matériau isolant thermiquement 35 recouvre les parois intérieures de l'enceinte 31 (cf. Fig.3). La cale 460 est donc fixe par rapport à l'enceinte 31 du four. Il peut être prévu plusieurs cales d'ajustement de hauteurs différentes afin de faire varier la distance entre l'extrémité inférieure du bouclier 38 et la surface du bain de silicium.

Dans le mode de réalisation de la figure 5, la rallonge de support 420 du système de translation est en forme de « L » et ne comprend que la première portion horizontale 421 et la deuxième portion verticale 422. En outre, le membre mobile 450 est configuré pour que la deuxième portion 422 de la rallonge de support 420 puisse glisser à l'intérieur du membre mobile 450. Une butée 470 aménagée à l'intérieur du membre mobile 450 empêche que la rallonge de support 420 ne sorte complètement du membre mobile 450.

Ce deuxième mode de réalisation du système de translation 40 fonctionne sensiblement de la même manière que le premier mode de réalisation. Une fois le bouclier 38 abaissé et la première portion 421 de la rallonge en contact avec la cale 460, le mouvement du membre mobile 450 peut être poursuivi pour abaisser davantage la pièce 12. Le membre mobile 450 coulisse alors autour de la deuxième portion 422 de la rallonge 420.

De nouveau en référence à la figure 3, le creuset 11 et le lingot 14 sont entraînés en rotation dans des sens contraires au cours de la cristallisation. La pièce 12 peut être également entraînée en rotation, de préférence dans le même sens de rotation et à la même vitesse que le creuset 11. Il n'y a alors plus de mouvement relatif de rotation entre le creuset 11 et la pièce 12. Cela permet de minimiser les flux du silicium en fusion à la périphérie du creuset, ces flux étant susceptibles d'atteindre le centre du creuset et d'altérer la cristallisation du lingot 14.

L'enrichissement du bain 10 au moyen de la pièce 12 s'effectue par deux mécanismes simultanés : d'une part par diffusion de l'oxygène au sein du matériau de la pièce 12 puis incorporation dans le bain de silicium 10, et d'autre part, par dissolution du matériau de la pièce 12. Toutefois, le coefficient de diffusion de l'oxygène dans le quartz ou la silice est si faible (typiquement 0,2 $\mu$m par heure dans la silice vitreuse) que le mécanisme par diffusion est négligeable devant le mécanisme par dissolution.

L'enrichissement en impureté (tel que l'oxygène) d'un bain de silicium par dissolution du creuset a déjà été étudié. Par exemple, l'article [« The accuracy of the standard resistivity-concentration conversion practice estimated by measuring the segregation coefficient of boron and phosphorous in Cz-Si », A. Giannattasio et al., Phys. Status Solidi A, Volume 208, Issue 3, 2011], enseigne que le gradient temporel de la concentration en oxygène [Oi] du bain (i.e. la variation de la concentration [Oi] par unité de temps) causé par la dissolution d'un creuset en quartz s'écrit de la façon suivante :

$$\frac{d[Oi]}{dt}\bigg|_c = \gamma_C \Sigma_C f_C \frac{N_A}{m_o V}$$

où $\gamma_C$ est la vitesse de dissolution du creuset dans le bain de silicium en fusion (en g/s/cm$^2$), $\Sigma_C$ est la surface de contact entre le creuset et le bain (en cm$^2$), $f_C$ la fraction massique d'oxygène dans le quartz (sans unité), $N_A$ la constante d'Avogadro (en mol$^{-1}$), $m_o$ la masse molaire de l'oxygène (en g/mol) et V le volume du bain de silicium (en cm$^3$).

Par analogie, le gradient temporel de la concentration en oxygène [Oi] du bain causé par la dissolution de la pièce 12 dans le bain s'écrit :

$$\frac{d[Oi]}{dt}\bigg|_p = \gamma_p \Sigma_p f_p \frac{N_A}{m_o V}$$

où $\gamma_p$ est la vitesse de dissolution de la pièce 12 dans le bain (en g/s/cm$^2$), $\Sigma_p$ est la surface de contact entre la pièce et le bain (en cm$^2$) et $f_p$ la fraction massique d'oxygène dans la pièce (sans unité).

Par conséquent, le gradient temporel « total » de la concentration en oxygène [Oi] du bain, correspondant aux contributions cumulées du creuset et de la pièce 12, s'écrit :

$$\frac{d[Oi]}{dt} = \frac{N_A}{m_o V}\left(\gamma_p \Sigma_p f_p + \gamma_C \Sigma_C f_C\right) \qquad (1)$$

La surface de contact $\Sigma_p$ entre la pièce 12 et le bain de silicium est une fonction de la profondeur h. Par conséquent, pour déterminer à chaque instant au cours de la cristallisation à quelle profondeur h la pièce 12 doit être plongée dans le bain, le procédé de fabrication peut comprend une étape de calcul de la surface de contact $\Sigma_p$.

La surface $\Sigma_p$ est calculée pour chaque fraction $f_s$ du lingot, à partir d'une concentration en oxygène cible $[Oi]_{tg}(f_s)$ souhaitée pour cette fraction. La fraction $f_s$ du lingot est la hauteur relative du lingot. Elle représente une position longitudinale dans le lingot et s'exprime habituellement entre 0% et 100 %.

La concentration en oxygène cible $[Oi]_{tg}(f_s)$ est la concentration en oxygène que l'on souhaite atteindre dans une fraction $f_s$ du lingot. Elle est, de préférence, convertie en un pourcentage x de la concentration en oxygène de base de cette même fraction, c'est-à-dire en valeur relative. Par « concentration en oxygène de base », on entend la concentration en oxygène du lingot obtenue en l'absence de la pièce 12, à creuset, charge de silicium et recette de tirage identiques. Ainsi, pour augmenter de x % (x peut être supérieur à 100 si on veut plus que doubler la concentration en oxygène) la concentration en oxygène de base de lingot, la contribution de la pièce 12 dans l'augmentation de la concentration en oxygène [Oi] doit être égale à x % de la contribution du creuset, d'où :

$$\gamma_p \Sigma_p f_p = \frac{x}{100} \cdot \gamma_C \Sigma_C f_C$$

soit :

$$\Sigma_p = \frac{x}{100} \cdot \frac{\gamma_C f_C}{\gamma_p f_p} \Sigma_C \qquad (2).$$

Dans le cas où la pièce 12 est constituée du même matériau que le creuset, la relation (2) ci-dessus se simplifie sous la forme suivante :

$$\Sigma_p = \frac{x}{100} \cdot \Sigma_c \qquad (2')$$

On constate donc que le fait d'utiliser le même matériau pour le creuset et la pièce 12 simplifie les calculs et évite d'avoir à déterminer les paramètres $\gamma_C$, $\gamma_p$, $f_C$ et $f_p$.

Connaissant la valeur de x pour chaque fraction $f_s$ du lingot et la surface de contact $\Sigma_c$ entre le creuset et le bain, la surface de contact $\Sigma_p$ entre la pièce en anneau et le bain peut être calculée en utilisant la relation (2') (ou (2) lorsque les matériaux du creuset et de la pièce sont différents). La surface de contact $\Sigma_c$ entre le creuset et le bain dépend logiquement de la géométrie de creuset et du volume de la charge fondue de silicium.

La surface de contact $\Sigma_p$ entre la pièce 12 et le bain est une fonction de la profondeur h, qui peut être déterminée en prenant en compte la géométrie de la pièce. Par exemple, dans le cas de la pièce 12 représentée sur la figure 2, la surface de contact $\Sigma_p(h)$ vaut :

$$\Sigma_p(h) = 4\pi R_1 h \cdot \sqrt{1 + \left(\frac{R_1 - R_2}{H}\right)^2}$$

où $R_1$ est le diamètre moyen de l'anneau, $R_2$ est le diamètre intérieur de l'anneau et H la hauteur totale de la pièce en forme d'anneau.

Cette formule mathématique permet de déterminer la profondeur $h(f_s)$ correspondant à la cristallisation d'une fraction $f_s$ du lingot, à partir de la surface de contact $\Sigma_p(f_s)$ précédemment calculée pour cette fraction.

En injectant la formule de $\Sigma_p(h)$ ci-dessus dans la relation (2') (ou (2) lorsque les matériaux du creuset et de la pièce sont différents), on obtient directement la fonction $h(f_s)$ :

$$h(f_s) = \frac{x}{100} \cdot \frac{\Sigma_c(f_s)}{4\pi R_1 \cdot \sqrt{1 + \left(\frac{R_1 - R_2}{H}\right)^2}} \qquad (3)$$

On s'affranchit ainsi du calcul de la surface de contact $\Sigma_p$ entre la pièce 12 et le bain pour déterminer la profondeur $h(f_s)$.

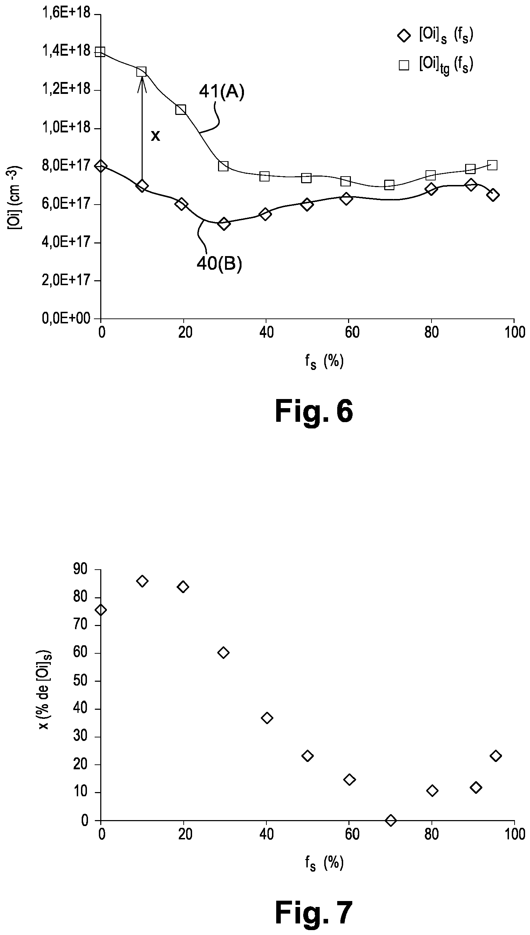

Les figures 6 à 9 représentent un exemple de mise en œuvre des étapes pour déterminer la profondeur h à laquelle plonger la pièce de la figure 2 lors de la cristallisation d'un lingot A enrichi en oxygène. Dans cet exemple, le lingot A est tiré selon la méthode Czochralski en utilisant un creuset de 50 cm de diamètre (intérieur) et une charge de silicium de 60 kg environ.

La figure 6 montre une courbe 40 de la concentration en oxygène de base $[Oi]_s$ le long du lingot A enrichi en oxygène, c'est-à-dire la concentration en oxygène de base $[Oi]_s$ pour différentes fractions $f_s$ du lingot A. La concentration en oxygène de base $[Oi]_s$ est, de préférence, déterminée en cristallisant un lingot de référence B, puis en mesurant la concentration en oxygène $[Oi]$ le long de ce lingot de référence. Le lingot de référence B est cristallisé dans les mêmes conditions que le lingot A enrichi en oxygène, sauf qu'aucune pièce 12 n'est introduite dans le bain de silicium en fusion. Le creuset, la charge de silicium et les paramètres de tirage utilisés pour cristalliser le lingot de référence B sont identiques à ceux utilisés pour cristalliser le lingot A. La concentration en oxygène $[Oi]$ peut être mesurée par spectrométrie infrarouge à transformée de Fourier appliquée à l'échelle du lingot entier (« Wholerod FTIR » en anglais).

Ainsi, en seulement deux opérations, respectivement de tirage et de mesure, on détermine la concentration en oxygène de base de tous les lingots qui seront cristallisés en suivant la même recette de tirage. Le procédé de fabrication selon l'invention ne demande donc pas une expérimentation longue et coûteuse pour être mise en œuvre, à la différence de certains procédés de l'art antérieur.

La courbe 40 de la figure 6 peut être appelée « profil longitudinal » de la concentration en oxygène de base $[Oi]_s$, en référence au fait que les mesures de la concentration en oxygène sont réparties sur l'axe longitudinal du lingot de référence B. Sur la figure 6, on a également représenté le profil longitudinal 41 de la concentration en oxygène

« cible » $[Oi]_{tg}(f_s)$ visée pour le lingot A.

La figure 7 représente, en fonction de la fraction $f_s$ du lingot, le pourcentage x de la concentration en oxygène de base $[Oi]_s$ nécessaire pour atteindre le profil cible 41 de la concentration en oxygène $[Oi]_{tg}(f_s)$ du lingot A. Le pourcentage x est calculé à partir de la différence entre les profils $[Oi]_{tg}(f_s)$ et $[Oi]_s(f_s)$ de la figure 6, d'après la formule suivante :

$$x(f_s) = 100 \cdot \frac{[Oi]_{tg}(f_s) - [Oi]_s(f_s)}{[Oi]_s(f_s)}$$

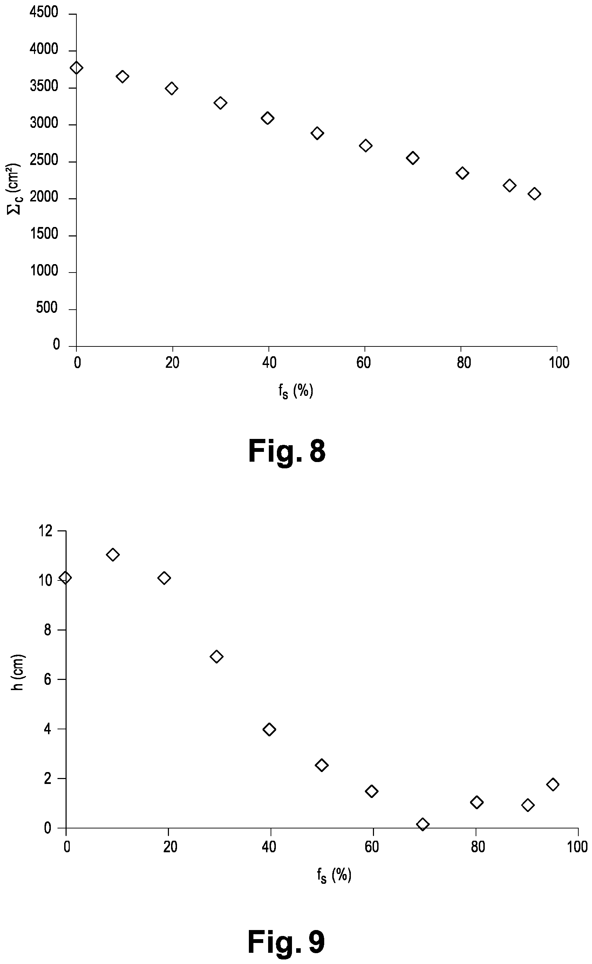

La figure 8 représente les variations de la surface de contact $\Sigma_c$ entre le creuset et le bain de silicium au cours de la cristallisation du lingot A, compte tenu du diamètre du creuset (50 cm) et de la masse de silicium utilisée (60 kg).

Enfin, la profondeur h de la pièce riche en oxygène est calculée pour chaque fraction du lingot A en utilisant la relation (4) ci-dessus, à partir des valeurs de x et de $\Sigma_c$ représentées sur les figures 7 et 8 respectivement. La pièce présente dans cet exemple une hauteur totale H égale à 11 cm, un diamètre moyen $R_1$ égal à 21,5 cm et un diamètre intérieur $R_2$ égal à 18 cm.

La figure 9 représente le résultat du calcul de la profondeur h.

Grâce au procédé de fabrication qui vient d'être décrit, il donc possible d'obtenir un lingot en silicium cristallin ayant une concentration en oxygène selon un profil particulier. À titre d'exemple, on peut souhaiter uniformiser la concentration en oxygène dans le lingot (soit un profil $[Oi]_{tg}(f_s)$ constant) ou, comme cela est représenté sur la figure 6, disposer d'une concentration en oxygène particulièrement élevée en tête de lingot ($f_s$ < 30 %) et bien plus faible dans le reste du lingot. Uniformiser la concentration en oxygène dans un lingot en silicium permet de l'exploiter au maximum, car toutes les plaquettes issues de ce lingot rempliront les spécifications relatives à la concentration en oxygène. Cela permet notamment d'accroître le rendement de fabrication des substrats en silicium qui serviront ensuite à fabriquer des dispositifs semi-conducteurs, tels que des cellules photovoltaïques. Le fait d'avoir plus d'oxygène en tête de lingot permet par exemple de compenser le faible dopage au phosphore en tête de lingot de type n (dû au phénomène de ségrégation) par la formation prononcée de donneurs thermiques.

Lorsque des valeurs de la concentration en oxygène cible $[Oi]_{tg}$ (Fig.6 ; courbe 41) sont trop élevées pour être atteintes avec une seule pièce 12 riche en oxygène (la profondeur h de la pièce 12 est limitée par la hauteur du creuset occupée par le bain), il est possible d'utiliser une deuxième pièce riche en oxygène, en plus de la première. Cette deuxième pièce aura, par exemple, une extrémité inférieure plane (plutôt qu'en pointe), offrant ainsi une surface de contact $\Sigma_p$ importante dès le début de la cristallisation. Il est également envisagé d'utiliser une seule pièce 12 dont les surfaces sont microstructurées, plutôt que planes, afin d'obtenir une augmentation plus importante de la surface $\Sigma_p$ en fonction de la hauteur h.

Bien que le procédé de fabrication ait été décrit en relation avec un lingot en silicium, il pourrait être appliqué à d'autres matériaux semi-conducteurs, par exemple le germanium ou l'alliage silicium-germanium.

**Revendications**

1. Four de cristallisation d'un lingot (14) en matériau semi-conducteur comprenant :

   - un creuset (11) ayant un axe de symétrie (z) et destiné à contenir un bain (10) de matériau semi-conducteur en fusion ;
   - un système de tirage (36) du lingot à partir du bain de matériau semi-conducteur en fusion, dans une direction colinéaire à l'axe de symétrie (z) du creuset (11) ; et
   - une pièce (12) constituée d'un matériau contenant de l'oxygène et comprenant au moins un segment d'un anneau, d'axe colinéaire à l'axe de symétrie (z) du creuset (11), la pièce (12) étant destinée à être plongée dans le bain (10) de matériau semi-conducteur en fusion pour l'enrichir en oxygène, le creuset (11) et la pièce (12) étant montés de façon à pouvoir exécuter un mouvement relatif de translation parallèlement à l'axe de symétrie (z) du creuset ;

   **caractérisé en ce qu'**il comprend en outre un bouclier thermique (38) disposé autour de l'axe de symétrie (z) du creuset (11) et monté mobile en translation parallèlement à l'axe de symétrie du creuset au moyen d'un système de translation (40) et **en ce que** la pièce (12) est fixée au système de translation (40) du bouclier thermique (38).

2. Four selon la revendication 1, dans lequel le système de translation (40) est conçu pour translater le bouclier thermique (38) et la pièce (12) simultanément et pour translater la pièce (12) indépendamment du bouclier thermique (38).

3. Four selon l'une des revendications 1 et 2, dans lequel dans lequel la pièce (12) est en outre montée en rotation autour de l'axe de symétrie (z) du creuset (11).

## Patentansprüche

1. Ofen zum Kristallisieren eines Blocks (14) aus Halbleitermaterial, umfassend:

- einen Tiegel (11) mit einer Symmetrieachse (z), der bestimmt ist, ein Bad (10) schmelzenden Halbleitermaterials zu enthalten;
- ein Zugsystem (36) des Blocks ab dem Bad schmelzenden Halbleitermaterials in eine Richtung, die zu der Symmetrieachse (z) des Tiegels (11) kollinear ist; und
- ein Teil (12), bestehend aus einem Material, das Sauerstoff enthält, und umfassend mindestens ein Segment eines Rings mit einer Achse, die zur Symmetrieachse (z) des Tiegels (11) kollinear ist, wobei das Teil (12) bestimmt ist, in das Bad (10) schmelzenden Halbleitermaterials getaucht zu werden, um es mit Sauerstoff anzureichern, wobei der Tiegel (11) und das Teil (12) derart angebracht sind, dass sie eine relative Verlagerungsbewegung parallel zur Symmetrieachse (z) des Tiegels ausführen können;

dadurch gekennzeichnet, dass er ferner einen Hitzeschild (38) umfasst, der um die Symmetrieachse (z) des Tiegels (11) angeordnet ist und mittels eines Verlagerungssystems (40) parallel zur Symmetrieachse des Tiegels translatorisch beweglich angebracht ist und dass das Teil (12) am Verlagerungssystem (40) des Hitzeschilds (38) befestigt ist.

2. Ofen nach Anspruch 1, wobei das Verlagerungssystem (40) konzipiert ist, um den Hitzeschild (38) und das Teil (12) gleichzeitig zu verlagern und um das Teil (12) unabhängig vom Hitzeschild (38) zu verlagern.

3. Ofen nach einem der Ansprüche 1 und 2, wobei das Teil (12) ferner rotierend um die Symmetrieachse (z) des Tiegels (11) angebracht ist.

## Claims

1. Furnace for crystallising an ingot (14) made of semiconductor material comprising:

- a crucible (11) which has a symmetry axis (z) and is intended to contain a melt (10) of semiconductor material;
- a system (36) for pulling the ingot from the melt of semiconductor material in a direction collinear with the symmetry axis (z) of the crucible (11); and
- a piece (12) made of an oxygen-containing material and comprising at least one segment of a ring with an axis collinear with the symmetry axis (z) of the crucible (11), the piece (12) being intended to be immersed in the melt (10) of semiconductor material to enrich it with oxygen, the crucible (11) and the piece (12) being mounted so as to be able to carry out a relative translational movement parallel to the symmetry axis (z) of the crucible;

characterised in that it further comprises a heat shield (38) arranged around the symmetry axis (z) of the crucible (11) and mounted to move in translation parallel to the symmetry axis of the crucible by means of a translation system (40) and in that the piece (12) is fastened to the translation system (40) of the heat shield (38).

2. Furnace according to claim 1, wherein the translation system (40) is designed to move the heat shield (38) and the piece (12) simultaneously in translation and to move the piece (12) in translation independently of the heat shield (38).

3. Furnace according to one of claims 1 and 2, wherein the piece (12) is further mounted for rotation around the symmetry axis (z) of the crucible (11).

**Fig. 1A**

**Fig. 1B**

**Fig. 2**

**Fig. 3**

Fig. 4

Fig. 5

**Fig. 6**

**Fig. 7**

**Fig. 8**

**Fig. 9**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 4545849 A
- DE 3215620 A1
- US 5853480 A

**Littérature non-brevet citée dans la description**

- **A. GIANNATTASIO et al.** The accuracy of the standard resistivity-concentration conversion practice estimated by measuring the segregation coefficient of boron and phosphorous in Cz-Si. *Phys. Status Solidi A,* 2011, vol. 208 (3